# EUROPEAN PATENT APPLICATION

(11) **EP 4 156 300 A1**
(43) Date of publication of application: **29.03.2023**
(21) Application number: 20943407.5
(22) Date of filing: 30.06.2020
(51) Int. Cl.: H01L 29/78, H01L 21/336

(54) **SEMICONDUCTOR DEVICE AND MANUFACTURING METHOD THEREFOR AND ELECTRONIC DEVICE**

(71) Applicant: Huawei Technologies Co., Ltd., Longgang District, Shenzhen, Guangdong 518129 (CN)
(72) Inventor: WAN, Guangxing, Shenzhen, Guangdong 518129 (CN); WONG, Waisum, Shenzhen, Guangdong 518129 (CN)
(74) Representative: Gill Jennings & Every LLP
(86) International application number: PCT/CN2020/099219
(87) International publication number: WO 2022/000257

(57) **Abstract**

A semiconductor device and a manufacturing method thereof, and an electronic device, relates to the field of semiconductor technologies are provided. The semiconductor device includes vertical gate all around transistors with different gate lengths. The semiconductor device includes: a substrate (01) and a first semiconductor fin (Z1) and a second semiconductor fin (Z2) that are located on the substrate (01). The first semiconductor fin (Z1) includes a plurality of stacked isolation semiconductor pattern layers and at least one channel semiconductor pattern layer, and each channel semiconductor pattern layer is sandwiched between two isolation semiconductor pattern layers. The second semiconductor fin (Z2) includes a first isolation semiconductor pattern layer, a first channel semiconductor layer, and a second isolation semiconductor pattern layer that are successively stacked. A total thickness of all channel semiconductor pattern layers in the first semiconductor fin (Z1) is different from a thickness of the first channel semiconductor pattern layer in the second semiconductor fin (Z2).

## Description

### TECHNICAL FIELD

This application relates to the field of semiconductor technologies, and in particular, to a semiconductor device and a manufacturing method thereof, and an electronic device.

### BACKGROUND

With continuous scaling of a metal oxide semiconductor field effect transistor (metal oxide semiconductor field effect transistor, MOSFET) device, a vertical gate all around (vertical gate all around, VGAA) transistor (hereinafter referred to as a VGAA device) is gradually applied, and is also considered as a future development direction.

For the VGAA device, it is extremely difficult to manufacture VGAA devices with different gate lengths at the same time because of a change of a channel direction. Therefore, currently, research almost focuses on implementation of short channel devices with a same gate length.

### SUMMARY

This application provides a semiconductor device and a manufacturing method thereof, and an electronic device, and provides a semiconductor device that includes vertical gate all around transistors with different gate lengths.

An embodiment of this application provides a semiconductor device, including a substrate and a first semiconductor fin and a second semiconductor fin that are located on the substrate. The first semiconductor fin includes a plurality of stacked isolation semiconductor pattern layers and at least one channel semiconductor pattern layer, and each channel semiconductor pattern layer is sandwiched between two isolation semiconductor pattern layers. The second semiconductor fin includes a first isolation semiconductor pattern layer, a first channel semiconductor layer, and a second isolation semiconductor pattern layer that are successively stacked. A total thickness of all channel semiconductor pattern layers in the first semiconductor fin is different from a thickness of the first channel semiconductor pattern layer.

In the semiconductor device, a first vertical gate all around transistor and a second vertical gate all around transistor have different gate lengths, thereby increasing an application range of the semiconductor device. For example, a requirement of an analog circuit on vertical gate all around transistors with different gate lengths can be met.

In some possible implementations, semiconductor materials in a channel semiconductor pattern layer closest to the substrate in the first semiconductor fin and the first channel semiconductor pattern layer are the same. In this case, in actual manufacturing, the channel semiconductor pattern layer closest to the substrate in the first semiconductor fin and the first channel semiconductor pattern layer can be prepared by using a same channel semiconductor layer, thereby simplifying a process and reducing manufacturing costs.

In some possible implementations, the first semiconductor fin includes a third isolation semiconductor pattern layer, a second channel semiconductor pattern layer, and a fourth isolation semiconductor pattern layer that are successively disposed on the substrate. A thickness of the second channel semiconductor pattern layer is different from the thickness of the first channel semiconductor pattern layer. Therefore, the first vertical gate all around transistor and the second vertical gate all around transistor with different channel lengths can be obtained.

In some possible implementations, the third isolation semiconductor pattern layer is closer to the substrate relative to the fourth isolation semiconductor pattern layer. The first isolation semiconductor pattern layer is closer to the substrate relative to the second isolation semiconductor pattern layer. Thicknesses of the third isolation semiconductor pattern layer and the first isolation semiconductor pattern layer are the same, and semiconductor materials in the third isolation semiconductor pattern layer and the first isolation semiconductor pattern layer are the same. Thicknesses of the fourth isolation semiconductor pattern layer and the second isolation semiconductor pattern layer are the same, and semiconductor materials in the fourth isolation semiconductor pattern layer and the second isolation semiconductor pattern layer are the same.

In this case, in actual manufacturing, the third isolation semiconductor pattern layer and the first isolation semiconductor pattern layer can be prepared by using a same isolation semiconductor layer, and the fourth isolation semiconductor pattern layer and the second isolation semiconductor pattern layer can be prepared by using a same isolation semiconductor layer. That is, the third isolation semiconductor pattern layer and the first isolation semiconductor pattern layer are in a same layer and are of same materials, and the fourth isolation semiconductor pattern layer and the second isolation semiconductor pattern layer are in a same layer and are of same materials, thereby simplifying a process and reducing manufacturing costs.

In some possible implementations, the first semiconductor fin includes a fifth isolation semiconductor pattern layer, a third channel semiconductor pattern layer, a sixth isolation semiconductor pattern layer, a fourth channel semiconductor pattern layer, and a seventh isolation semiconductor pattern layer that are successively disposed on the substrate. A thickness of the third channel semiconductor pattern layer is the same as the thickness of the first channel semiconductor pattern layer. Therefore, the first vertical gate all around transistor and the second vertical gate all around transistor with different channel lengths can be obtained.

In some possible implementations, semiconductor materials in the first channel semiconductor pattern layer and the second channel semiconductor pattern layer are the same. In this case, in actual manufacturing, the first channel semiconductor pattern layer and the second channel semiconductor pattern layer can be obtained by using a same channel semiconductor layer, and are prepared in a local etching and thinning manner. That is, the first channel semiconductor pattern layer and the second channel semiconductor pattern layer are in a same layer and are of same materials, thereby simplifying a process and reducing manufacturing costs.

In some possible implementations, the fifth isolation semiconductor pattern layer is closer to the substrate relative to the sixth isolation semiconductor pattern layer. The first isolation semiconductor pattern layer is closer to the substrate relative to the second isolation semiconductor pattern layer. Thicknesses of the fifth isolation semiconductor pattern layer and the first isolation semiconductor pattern layer are the same, and semiconductor materials in the fifth isolation semiconductor pattern layer and the first isolation semiconductor pattern layer are the same. Thicknesses of the sixth isolation semiconductor pattern layer and the second isolation semiconductor pattern layer are the same, and semiconductor materials in the sixth isolation semiconductor pattern layer and the second isolation semiconductor pattern layer are the same.

In this case, in actual manufacturing, the fifth isolation semiconductor pattern layer and the first isolation semiconductor pattern layer can be prepared by using a same isolation semiconductor layer. The sixth isolation semiconductor pattern layer and the second isolation semiconductor pattern layer can be prepared by using a same isolation semiconductor layer. That is, the fifth isolation semiconductor pattern layer and the first isolation semiconductor pattern layer are in a same layer and are of same materials, and the sixth isolation semiconductor pattern layer and the second isolation semiconductor pattern layer are in a same layer and are of same materials, thereby simplifying a process and reducing manufacturing costs.

In some possible implementations, thicknesses of the first channel semiconductor pattern layer and the third channel semiconductor pattern layer are the same, and semiconductor materials in the first channel semiconductor pattern layer and the third channel semiconductor pattern layer are the same. In this case, in actual manufacturing, the first channel semiconductor pattern layer and the third channel semiconductor pattern layer can be prepared by using a same semiconductor layer. That is, the first channel semiconductor pattern layer and the third channel semiconductor pattern layer are in a same layer and are of same materials, thereby simplifying a process and reducing manufacturing costs.

In some possible implementations, in the first semiconductor fin, gate spacers are disposed on sides around isolation semiconductor pattern layers on both sides of each channel semiconductor pattern layer, and a gate insulation layer and a gate layer are successively disposed on sides around the channel semiconductor pattern layer and between two gate spacers. In the second semiconductor fin, gate spacers are disposed on sides around the first isolation semiconductor pattern layer and the second isolation semiconductor pattern layer, and a gate insulation layer and a gate layer are successively disposed on sides around the first channel semiconductor layer and between two gate spacers.

In some possible implementations, the substrate is a silicon substrate.

In some possible implementations, a material for forming the isolation semiconductor layer includes SiGe, and a material for forming the channel semiconductor layer includes Si.

In some possible implementations, a material for forming the isolation semiconductor layer includes Si, and a material for forming the channel semiconductor layer includes SiGe.

An embodiment of this application further provides a manufacturing method for a semiconductor device, including: forming an initial stacked semiconductor structure on a substrate, where the initial stacked semiconductor structure includes at least one isolation semiconductor layer and at least one channel semiconductor layer that are formed alternately on the substrate; etching the initial stacked semiconductor structure to form an intermediate stacked semiconductor structure, where the intermediate stacked semiconductor structure includes an effective channel semiconductor layer, the effective channel semiconductor layer is located between two isolation semiconductor layers, the effective channel semiconductor layer has a first thickness in a first area and a second thickness in a second area, the first thickness is different from the second thickness, and the first area and the second area are different areas; and etching the intermediate stacked semiconductor structure to form a first semiconductor fin structure in the first area and a second semiconductor fin structure in the second area.

By using the manufacturing method provided in this embodiment of this application, an effective channel semiconductor pattern layer having areas with different thicknesses can be manufactured through etching, and areas with different thicknesses of the effective channel semiconductor pattern layer are used as channel length areas of a vertical gate all around transistor subsequently. In addition, in a manufacturing procedure, a channel shape (for example, a cylindrical shape or a cube shape) of a vertical gate all around transistor can be further controlled based on an actual requirement through etching. That is, by using the manufacturing method in this application, at least two vertical gate all around transistors with different channel lengths (gate lengths) can be simultaneously manufactured by using one process, that is, a channel design degree of freedom of the vertical gate all around transistor is increased, and a long channel gate all around transistor and a short channel gate all around transistor can be simultaneously formed, thereby increasing an application range of the semiconductor device.

In some possible implementations, a top-layer epitaxial isolation semiconductor layer is disposed at an uppermost layer of the intermediate stacked semiconductor structure. Before the etching the intermediate stacked semiconductor structure, the manufacturing method for a semiconductor device further includes: performing planarization processing on an upper surface of the top-layer epitaxial isolation semiconductor layer to ensure planarity of the upper surface of the top-layer epitaxial isolation semiconductor layer, to facilitate manufacturing of another film layer at the top-layer epitaxial isolation semiconductor layer subsequently.

In some possible implementations, the forming an initial stacked semiconductor structure on a substrate includes: successively forming a first isolation semiconductor layer and a first channel semiconductor layer on the substrate to obtain the initial stacked semiconductor structure; and the etching the initial stacked semiconductor structure to form an intermediate stacked semiconductor structure includes: etching and thinning the first channel semiconductor layer located in the second area to form the effective channel semiconductor layer, and successively forming a second isolation semiconductor layer and a top-layer epitaxial isolation semiconductor layer at the effective channel semiconductor layer, so as to obtain the intermediate stacked semiconductor structure.

In some possible implementations, the forming an initial stacked semiconductor structure on a substrate includes: successively forming a first isolation semiconductor layer, a first channel semiconductor layer, a second isolation semiconductor layer, a second channel semiconductor layer, a third isolation semiconductor layer, and a first epitaxial isolation semiconductor layer on the substrate to obtain the initial stacked semiconductor structure; and the etching the initial stacked semiconductor structure to form an intermediate stacked semiconductor structure includes: etching the initial stacked semiconductor structure, and removing at least a film layer that is in the second area and that is located above the second channel semiconductor layer, to obtain an etched initial stacked semiconductor structure, where the etched initial stacked semiconductor structure includes the effective channel semiconductor layer, and the effective channel semiconductor layer includes one channel semiconductor layer in the second area, and includes two channel semiconductor layers in the first area; and forming a top-layer epitaxial isolation semiconductor layer on an upper surface of the etched initial stacked semiconductor structure, to obtain the intermediate stacked semiconductor structure.

In some possible implementations, the removing at least a film layer that is in the second area and that is located above the second channel semiconductor layer includes: removing the film layer that is in the second area and that is located above the second channel semiconductor layer, and reducing a thickness of the second channel semiconductor layer in the second area. Therefore, a manufacturing process with relatively low etching accuracy may be used in a manufacturing procedure, thereby reducing a manufacturing process requirement.

In some possible implementations, after the etching the intermediate stacked semiconductor structure to form a first semiconductor fin structure in the first area and a second semiconductor fin structure in the second area, the manufacturing method for a semiconductor device further includes: partially etching an isolation semiconductor layer in each of the first semiconductor fin structure and the second semiconductor fin structure to form a side wall groove, and filling the side wall groove with an insulation medium material to form a gate spacer; and etching a channel semiconductor layer between two gate spacers to form a channel groove, and forming a gate insulation layer and a gate layer that are successively disposed in the channel groove.

In some possible implementations, the forming a gate insulation layer and a gate layer that are successively disposed in the channel groove includes: forming, by using an HKMG process, a high dielectric constant insulation layer and a metal gate layer that are successively disposed in the channel groove. In this case, performance of a prepared vertical gate all around transistor can be improved, a gate leakage quantity can be reduced, and gate capacitance and a key size of the vertical gate all around transistor can be reduced.

In some possible implementations, before the forming an initial stacked semiconductor structure on a substrate, the manufacturing method for a semiconductor device further includes: disposing the substrate, and separately forming wells at positions corresponding to a plurality of to-be-formed vertical gate all around transistors on the substrate.

An embodiment of this application further provides an electronic device, including the semiconductor device in any one of the foregoing possible implementations.

### BRIEF DESCRIPTION OF DRAWINGS

FIG. 1 is a schematic diagram of a local structure of a semiconductor device according to an embodiment of this application;
FIG. 2 is a schematic diagram of a structure of a semiconductor fin part in a semiconductor device according to an embodiment of this application;
FIG. 3 is a schematic diagram of a structure of a semiconductor fin part in a semiconductor device according to an embodiment of this application;
FIG. 4 is a flowchart of a front end of line of a semiconductor device according to an embodiment of this application;
FIG. 5 is a flowchart of a front end of line of a semiconductor device according to Embodiment 1 of this application;
FIG. 6 is a schematic diagram of a structure of a semiconductor device in a manufacturing procedure according to Embodiment 1 of this application;
FIG. 7 is a schematic diagram of a structure of a semiconductor device in a manufacturing procedure according to Embodiment 1 of this application;
FIG. 8 is a schematic diagram of a structure of a semiconductor device in a manufacturing procedure according to Embodiment 1 of this application;
FIG. 9 is a schematic diagram of a structure of a semiconductor device in a manufacturing procedure according to Embodiment 1 of this application;
FIG. 10 is a schematic diagram of a structure of a semiconductor device in a manufacturing procedure according to Embodiment 1 of this application;
FIG. 11 is a schematic diagram of a structure of a semiconductor device in a manufacturing procedure according to Embodiment 1 of this application;
FIG. 12 is a schematic diagram of a structure of a semiconductor device in a manufacturing procedure according to Embodiment 1 of this application;
FIG. 13 is a schematic diagram of a structure of a semiconductor device after a front end of line is completed according to Embodiment 1 of this application;
FIG. 14 is a schematic diagram of a structure of a semiconductor device after a back end of line is completed according to Embodiment 1 of this application;
FIG. 15 is a flowchart of a front end of line of a semiconductor device according to Embodiment 2 of this application;
FIG. 16 is a schematic diagram of a structure of a semiconductor device in a manufacturing procedure according to Embodiment 2 of this application;
FIG. 17 is a schematic diagram of a structure of a semiconductor device in a manufacturing procedure according to Embodiment 2 of this application;
FIG. 18 is a schematic diagram of a structure of a semiconductor device in a manufacturing procedure according to Embodiment 2 of this application;
FIG. 19 is a schematic diagram of a structure of a semiconductor device in a manufacturing procedure according to Embodiment 2 of this application;
FIG. 20 is a schematic diagram of a structure of a semiconductor device in a manufacturing procedure according to Embodiment 2 of this application;
FIG. 21 is a schematic diagram of a structure of a semiconductor device in a manufacturing procedure according to Embodiment 2 of this application;
FIG. 22 is a schematic diagram of a structure of a semiconductor device in a manufacturing procedure according to Embodiment 2 of this application;
FIG. 23 is a schematic diagram of a structure of a semiconductor device after a front end of line is completed according to Embodiment 2 of this application; and
FIG. 24 is a schematic diagram of a structure of a semiconductor device after a back end of line is completed according to Embodiment 2 of this application.

### DESCRIPTION OF EMBODIMENTS

To make the objectives, technical solutions, and advantages of this application clearer, the following clearly describes the technical solutions of this application with reference to the accompanying drawings of this application. It is clear that the described embodiments are merely a part rather than all of embodiments of this application. All other embodiments obtained by a person of ordinary skill in the art based on embodiments of this application without creative efforts shall fall within the protection scope of this application.

The terms "first", "second", and the like in embodiments of the specification, claims, and accompanying drawings of this application are used only for distinguishing, and cannot be understood as indicating or implying relative importance, or as indicating or implying a sequence. In addition, the terms "include" and "have", as well as any of their variants, are intended to cover non-exclusive inclusion, such as, including a series of steps or units. Methods, systems, products, or devices are not limited to those steps or units that are clearly listed, but may include other steps or units that are not clearly listed or are inherent in these processes, methods, products, or devices. "Upper", "lower", and the like are used only with respect to orientations of components in the accompanying drawings. These orientation terms are relative concepts, are used for relative description and clarification, and may be correspondingly changed based on changes in the orientations in which the components are placed in the accompanying drawings.

An embodiment of this application provides an electronic device, and the electronic device includes a semiconductor device on which a plurality of vertical gate all around transistors are disposed. The electronic device may be an electronic product such as a mobile phone, a tablet computer, a notebook, a vehicle-mounted computer, a smart watch, or a smart band. This embodiment of this application sets no special limitation on a specific form of the electronic device.

In addition, this application also sets no special limitation on a specific form of the semiconductor device on which a plurality of vertical gate all around transistors are disposed. For example, the semiconductor device may be a chip, a substrate on which a control circuit is integrated inside the electronic device, or the like.

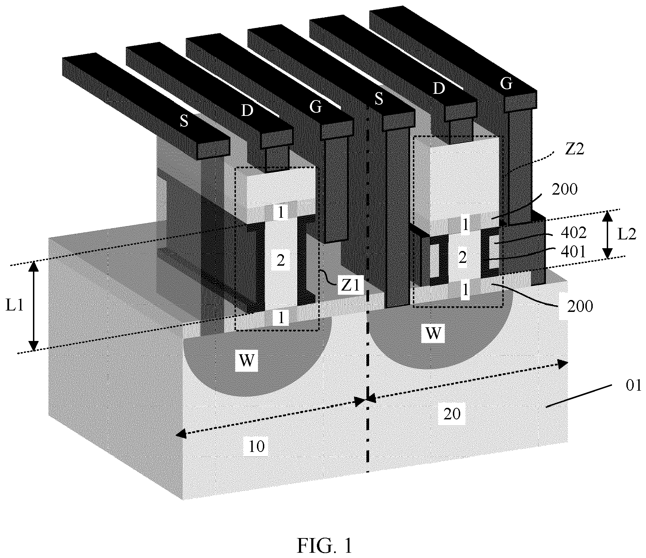

Referring to FIG. 1, the semiconductor device includes a substrate 01, a first vertical gate all around transistor 10 and a second vertical gate all around transistor 20 that are located on the substrate 01. The first vertical gate all around transistor 10 includes a first semiconductor fin Z1, and the second vertical gate all around transistor 20 includes a second semiconductor fin Z2. A schematic partial diagram of the semiconductor device shown in FIG. 1 is for schematically showing an entire channel area of the first vertical gate all around transistor 10, so that a part of a gate connected to the channel area is omitted.

As shown in FIG. 1, both the first semiconductor fin Z1 and the second semiconductor fin Z2 include a plurality of stacked isolation semiconductor pattern layers 1 and at least one channel semiconductor pattern layer 2, and each channel semiconductor pattern layer 2 is sandwiched between two isolation semiconductor pattern layers 1. FIG. 1 is merely a schematic diagram for description by using an example in which two isolation semiconductor pattern layers 1 and one channel semiconductor pattern layer 2 are disposed in both the first semiconductor fin Z1 and the second semiconductor fin Z2.

In the semiconductor device, a thickness sum (that is, a total thickness) of the channel semiconductor pattern layer 2 in the first semiconductor fin Z1 is different from a thickness sum (that is, a total thickness) of the channel semiconductor pattern layer 2 in the second semiconductor fin Z2. For both the first semiconductor fin Z1 and the second semiconductor fin Z2 in FIG. 1, a vertical gate all around transistor of one channel semiconductor pattern layer 2 is used, that is, a thickness L1 of the channel semiconductor pattern layer 2 in the first semiconductor fin Z1 is different from a thickness L2 of the channel semiconductor pattern layer 2 in the second semiconductor fin Z2 (L1#L2).

It may be understood by a person skilled in the art that, in a vertical gate all around transistor, a channel semiconductor pattern layer 2 is used as a channel layer of the transistor, and a thickness thereof is a channel length. Certainly, a gate insulation layer and a gate layer (for details, refer to the following) may be successively disposed on sides around the channel semiconductor pattern layer 2. Gate lengths (that is, gate lengths) of transistors with different channel lengths are also necessarily different. That is, in the semiconductor device provided in this embodiment of this application, a first vertical gate all around transistor and a second vertical gate all around transistor have different gate lengths, thereby increasing an application range of the semiconductor device. For example, a requirement of an analog circuit on vertical gate all around transistors with different gate lengths can be met.

A type of a vertical gate all around transistor (10, 20) is not limited in this application. The vertical gate all around transistor may be a nanowire gate all around transistor (that is, a nanowire FET), or may be a nanosheet gate all around transistor (that is, a nanosheet FET).

It should be noted that, for the first vertical gate all around transistor 10 and the second vertical gate all around transistor 20 that are located in the semiconductor device, it may be understood that the semiconductor device includes at least one first vertical gate all around transistor 10 and at least one second vertical gate all around transistor 20, for example, 1000 first vertical gate all around transistors 10 and 2000 second vertical gate all around transistors 20. For the first vertical gate all around transistor 10 and the second vertical gate all around transistor 20 themselves, the first vertical gate all around transistor 10 and the second vertical gate all around transistor 20 do not refer to two types of vertical gate all around transistors with specific gate lengths. The first vertical gate all around transistor 10 and the second vertical gate all around transistor 20 refer to only two types of opposite vertical gate all around transistors meeting the foregoing specific conditions. For example, when the semiconductor device includes three vertical gate all around transistors with different channel lengths (that is, gate lengths), in the three vertical gate all around transistors with different channel lengths, any two vertical gate all around transistors with different channel lengths may be respectively considered as the first vertical gate all around transistor 10 and the second vertical gate all around transistor 20.

The following further describes specific disposing manners of the isolation semiconductor pattern layer 1 and the channel semiconductor pattern layer 2 in the first semiconductor fin Z1 and the second semiconductor fin Z2 in the semiconductor device in this application.

### Disposing manner 1

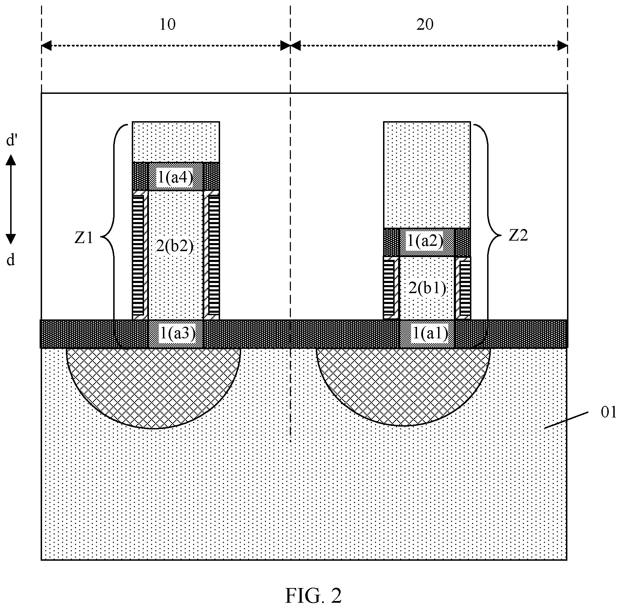

In some semiconductor devices, as shown in FIG. 2, the second semiconductor fin Z2 includes a first isolation semiconductor pattern layer a1, a first channel semiconductor pattern layer b1, and a second isolation semiconductor pattern layer a2 that are successively disposed on the substrate 01. The first isolation semiconductor pattern layer a1 is closer to the substrate 01 relative to the second isolation semiconductor pattern layer a2. The first semiconductor fin Z1 includes a third isolation semiconductor pattern layer a3, a second channel semiconductor pattern layer b2, and a fourth isolation semiconductor pattern layer a4 that are successively disposed on the substrate 01. The third isolation semiconductor pattern layer a3 is closer to the substrate 01 relative to the fourth isolation semiconductor pattern layer a4. A thickness of the first channel semiconductor pattern layer b1 is different from a thickness of the second channel semiconductor pattern layer b2, that is, a channel length of the first vertical gate all around transistor 10 is different from a channel length of the second vertical gate all around transistor 20.

In this disposing manner, in some possible implementations, thicknesses of the third isolation semiconductor pattern layer a3 and the first isolation semiconductor pattern layer a1 are the same, and semiconductor materials in the third isolation semiconductor pattern layer a3 and the first isolation semiconductor pattern layer a1 are the same. That is, to simplify a process and reduce manufacturing costs, in actual manufacturing, the third isolation semiconductor pattern layer a3 and the first isolation semiconductor pattern layer a1 may be prepared by using a same isolation semiconductor layer, that is, the third isolation semiconductor pattern layer a3 and the first isolation semiconductor pattern layer a1 are in a same layer and are of same materials.

In some possible implementations, thicknesses of the fourth isolation semiconductor pattern layer a4 and the second isolation semiconductor pattern layer a2 are the same, and semiconductor materials in the fourth isolation semiconductor pattern layer a4 and the second isolation semiconductor pattern layer a2 are the same. That is, to simplify a process and reduce manufacturing costs, in actual manufacturing, the fourth isolation semiconductor pattern layer a4 and the second isolation semiconductor pattern layer a2 may be prepared by using a same isolation semiconductor layer, that is, the fourth isolation semiconductor pattern layer a4 and the second isolation semiconductor pattern layer a2 are in a same layer and are of same materials.

In some possible implementations, semiconductor materials in the first channel semiconductor pattern layer b 1 and the second channel semiconductor pattern layer b2 are the same. That is, to simplify a process and reduce manufacturing costs, in actual manufacturing, the first channel semiconductor pattern layer b 1 and the second channel semiconductor pattern layer b2 may be obtained by using a same channel semiconductor layer, and are prepared in a local etching and thinning manner. That is, the first channel semiconductor pattern layer b1 and the second channel semiconductor pattern layer b2 are in a same layer and are of same materials.

### Disposing manner 2

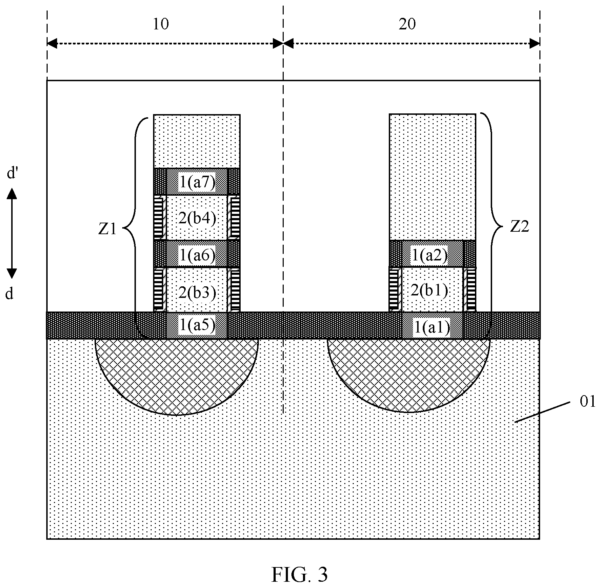

In some semiconductor devices, as shown in FIG. 3, the second semiconductor fin Z2 includes a first isolation semiconductor pattern layer a1, a first channel semiconductor pattern layer b1, and a second isolation semiconductor pattern layer a2 that are successively disposed on the substrate 01. The first isolation semiconductor pattern layer a1 is closer to the substrate 01 relative to the second isolation semiconductor pattern layer a2. The first semiconductor fin Z1 includes a fifth isolation semiconductor pattern layer a5, a third channel semiconductor pattern layer b3, a sixth isolation semiconductor pattern layer a6, a fourth channel semiconductor pattern layer b4, and a seventh isolation semiconductor pattern layer a7 that are successively disposed on the substrate 01. The fifth isolation semiconductor pattern layer a5 is closer to the substrate 01 relative to the seventh isolation semiconductor pattern layer a7. A thickness of the third channel semiconductor pattern layer b3 is the same as a thickness of the first channel semiconductor pattern layer b1. Then, a thickness sum of the third channel semiconductor pattern layer b3 and the fourth channel semiconductor pattern layer b4 is necessarily greater than the thickness of the first channel semiconductor pattern layer b1, that is, channel lengths of the first vertical gate all around transistor 10 and the second vertical gate all around transistor 20 are different.

In this disposing manner, in some possible implementations, thicknesses of the fifth isolation semiconductor pattern layer a5 and the first isolation semiconductor pattern layer a1 are the same, and semiconductor materials in the fifth isolation semiconductor pattern layer a5 and the first isolation semiconductor pattern layer a1 are the same. That is, to simplify a process and reduce manufacturing costs, in actual manufacturing, the fifth isolation semiconductor pattern layer a5 and the first isolation semiconductor pattern layer a1 may be prepared by using a same isolation semiconductor layer, that is, the fifth isolation semiconductor pattern layer a5 and the first isolation semiconductor pattern layer a1 are in a same layer and are of same materials.

In some possible implementations, thicknesses of the sixth isolation semiconductor pattern layer a6 and the second isolation semiconductor pattern layer a2 are the same, and semiconductor materials in the sixth isolation semiconductor pattern layer a6 and the second isolation semiconductor pattern layer a2 are the same. That is, to simplify a process and reduce manufacturing costs, in actual manufacturing, the sixth isolation semiconductor pattern layer a6 and the second isolation semiconductor pattern layer a2 may be prepared by using a same isolation semiconductor layer, that is, the sixth isolation semiconductor pattern layer a6 and the second isolation semiconductor pattern layer a2 are in a same layer and are of same materials.

In some possible implementations, the first channel semiconductor pattern layer b1 and the third channel semiconductor pattern layer b3 have same thicknesses, and further use same semiconductor materials. That is, to simplify a process and reduce manufacturing costs, in actual manufacturing, the first channel semiconductor pattern layer b1 and the third channel semiconductor pattern layer b3 may be prepared by using a same semiconductor layer. That is, the first channel semiconductor pattern layer b 1 and the third channel semiconductor pattern layer b3 are in a same layer and are of same materials.

It should be noted herein that "in a same layer and of same materials" in this application means that two (or more than two) pattern layers may be manufactured by using a same thin film, but the two pattern layers are not absolutely at a same height position. It may be understood that, different pattern layers may be disposed below a same thin film layer, so that the thin film itself is not entirely at a same height position, and therefore, a plurality of pattern layers formed by using the same thin film are not necessarily at a same height position. For example, the fourth isolation semiconductor pattern layer a4 and the second isolation semiconductor pattern layer a2 in FIG. 2 may be prepared by using a same isolation semiconductor layer, but are not located at a same height position.

In addition, a person skilled in the art may understand that, as shown in FIG. 1, a vertical gate all around transistor (for example, 10 or 20) includes a semiconductor fin (for example, Z1 or Z2), and further includes another component, such as a source (source, S), a drain (drain, D), a gate (gate, G), and a well (well, W).

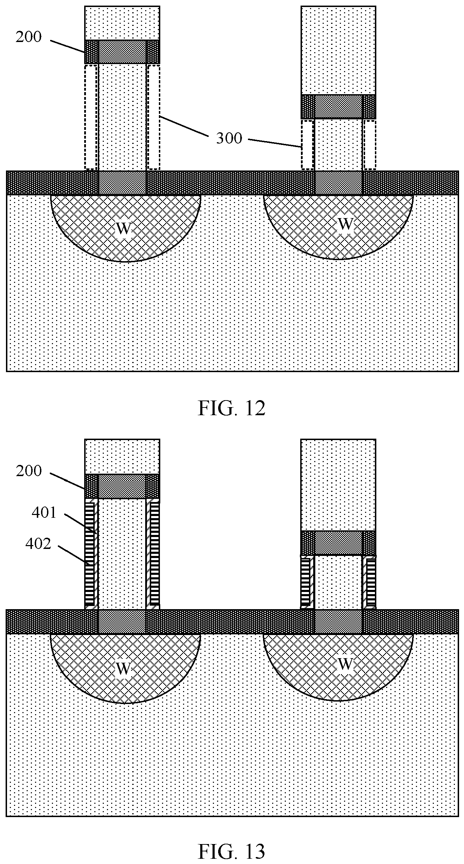

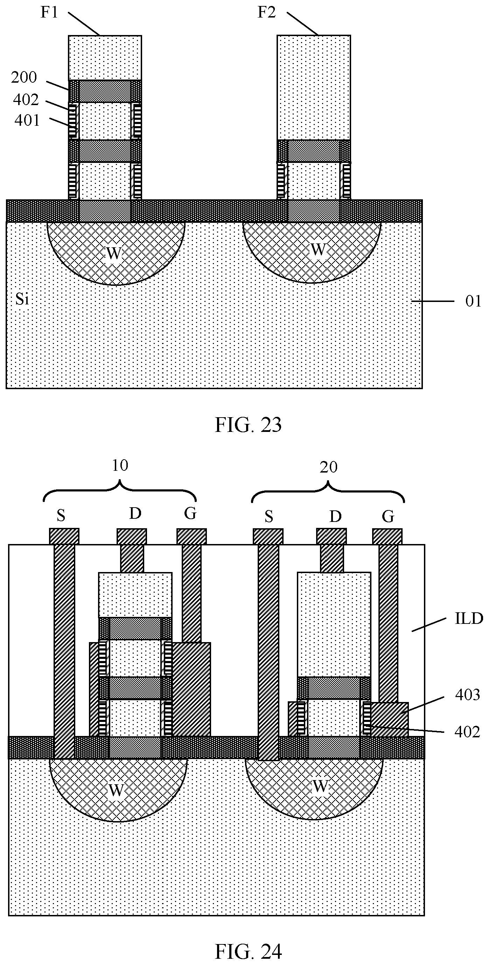

Schematically, referring to FIG. 1, in some possible implementations, in the first semiconductor fin Z1 and the second semiconductor fin Z2, gate spacers 200 are disposed on sides around isolation semiconductor pattern layers 1 on two sides of each channel semiconductor pattern layer 2, and a gate insulation layer 401 and a gate layer 402 are successively disposed on sides around the channel semiconductor pattern layer 1 and between two gate spacers 200. For specific schematic structures of the gate spacer 200, the gate insulation layer 401, and the gate layer 402 in FIG. 2 and FIG. 3, refer to FIG. 13 and FIG. 23, which are not shown herein.

A person skilled in the art may understand that, for manufacturing of the semiconductor device, a manufacturing process of the semiconductor device may generally include a front end of line (front end of line, FEOL) and a back end of line (back end of line, BEOL) for interconnection after the front end of line.

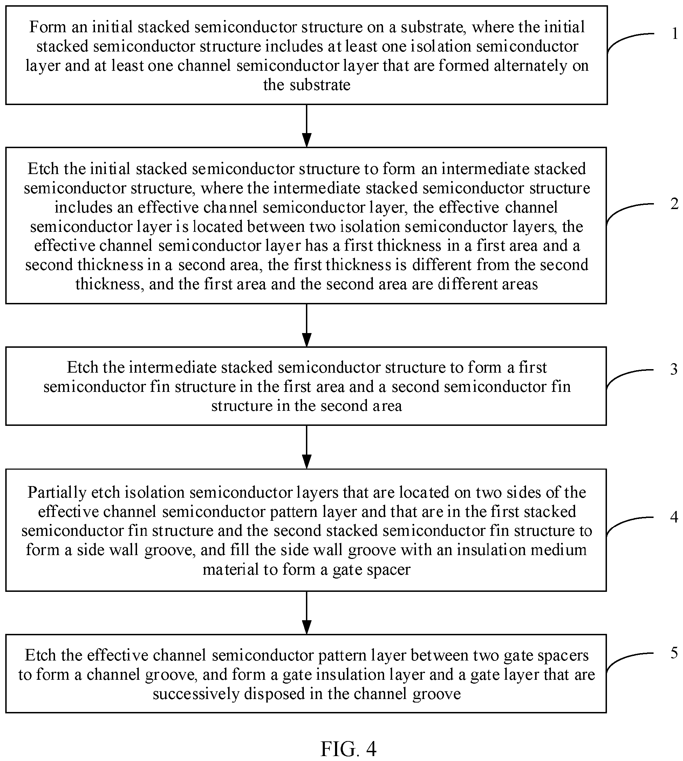

As shown in FIG. 4, an embodiment of this application provides a front end of line for manufacturing a semiconductor device, including:
Step 1: Form an initial stacked semiconductor structure P1 on a substrate 01, where the initial stacked semiconductor structure P1 includes at least one isolation semiconductor layer and at least one channel semiconductor layer that are formed alternately on the substrate.

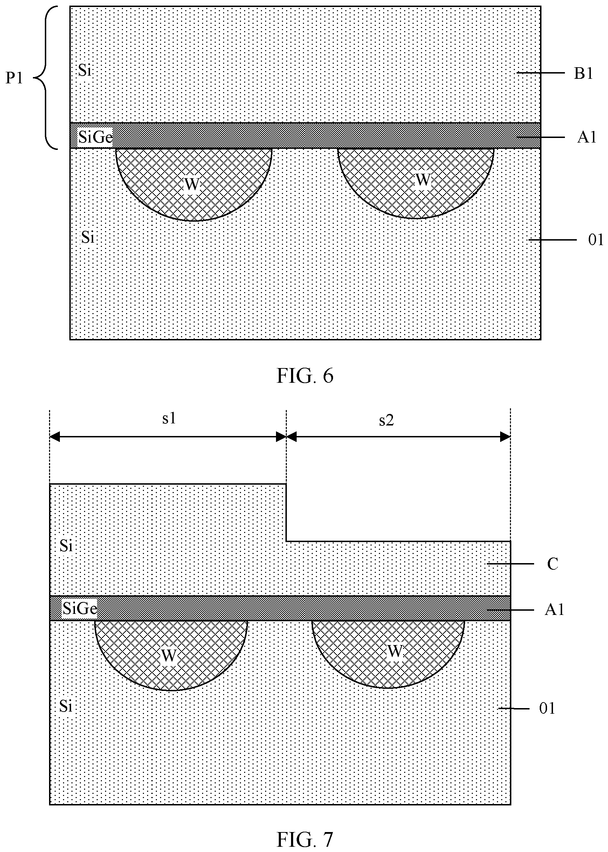

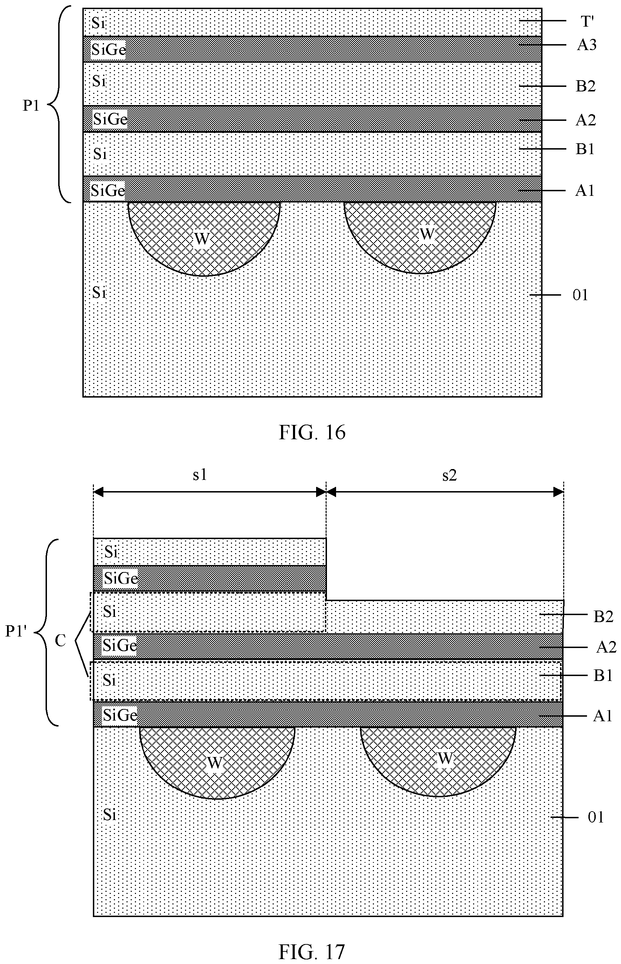

For example, for the initial stacked semiconductor structure P1, refer to FIG. 6 and FIG. 16.

For specific disposing manners of the isolation semiconductor layer and the channel semiconductor layer in the initial stacked semiconductor structure P1, refer to subsequent Embodiment 1 and Embodiment 2.

Step 2: Perform etching on the initial stacked semiconductor structure P1 to form an intermediate stacked semiconductor structure P2, where the intermediate stacked semiconductor structure P2 includes an effective channel semiconductor layer C, and the effective channel semiconductor layer C is located between two isolation semiconductor layers; the effective channel semiconductor layer has a first thickness in a first area s1 and a second thickness in a second area s2; and the first thickness is different from the second thickness, and the first area s1 and the second area s2 are different areas.

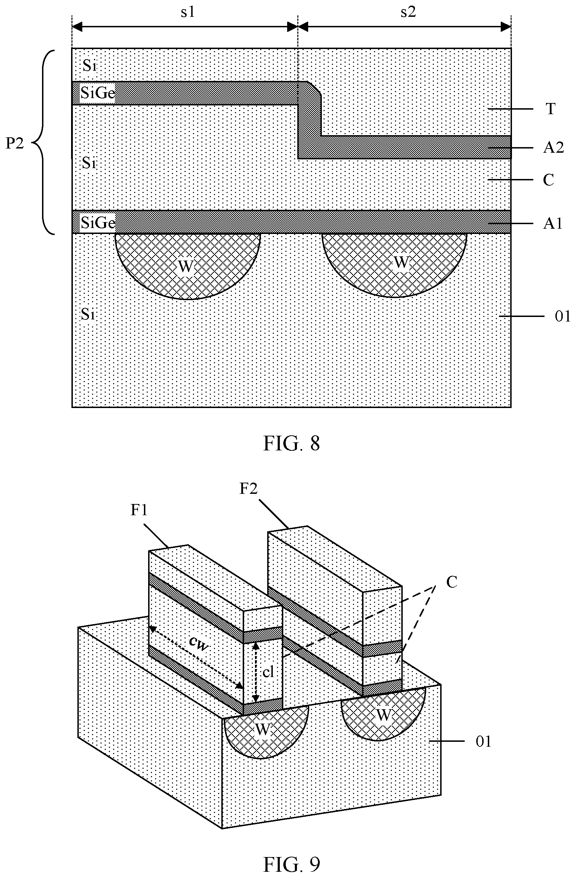

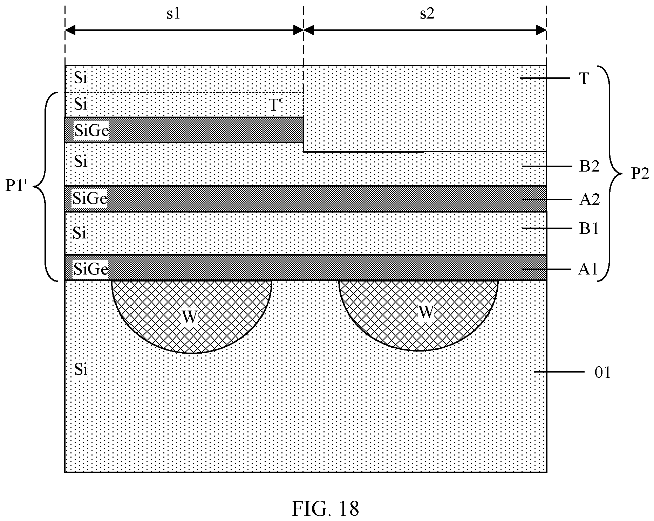

For example, for etching on the initial stacked semiconductor structure P1, refer to FIG. 7 and FIG. 17. For the formed intermediate stacked semiconductor structure, refer to FIG. 8 and FIG. 18. For specific disposing manners of the effective channel semiconductor layer C, refer to subsequent Embodiment 1 and Embodiment 2.

Step 3: Perform etching on the intermediate stacked semiconductor structure P2 to form a first semiconductor fin structure F1 in the first area s1, and a second semiconductor fin structure F2 in the second area s2.

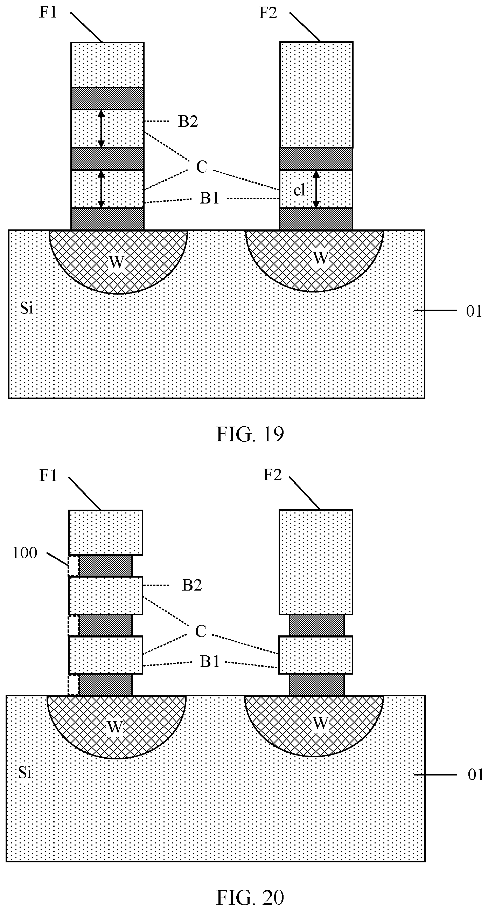

For example, for etching on the intermediate stacked semiconductor structure P2 to form F1 and F2, refer to FIG. 9 and FIG. 19.

Step 4: Perform partially etching on isolation semiconductor layers in the first semiconductor fin structure F1 and the second semiconductor fin structure F2 to form a side wall groove 100, and fill the side wall groove 100 with an insulation medium material to form a gate spacer 200.

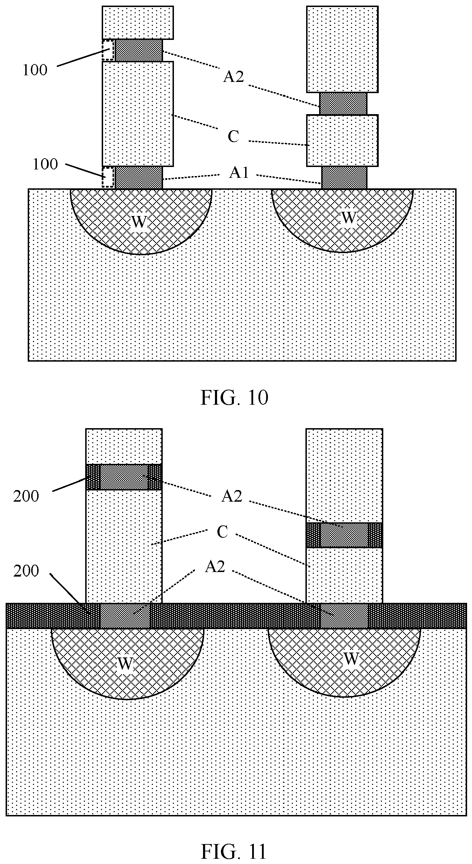

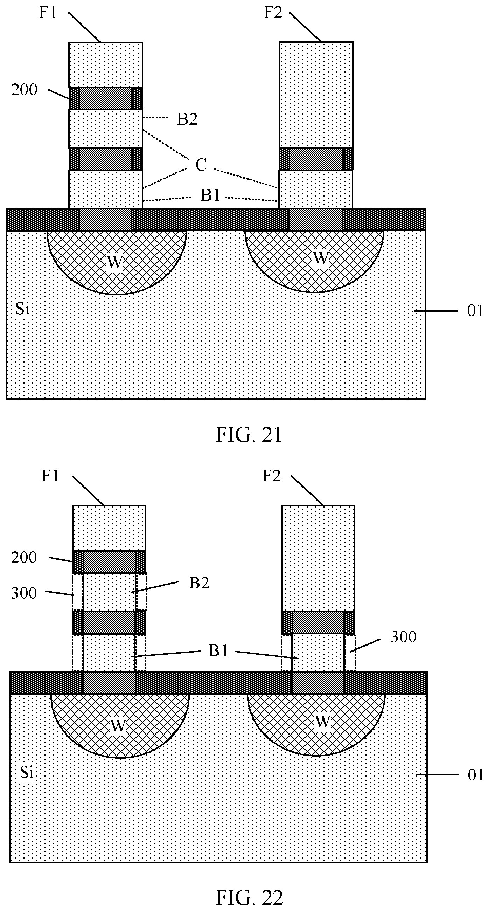

For example, for the side wall groove 100, refer to FIG. 10 and FIG. 20, and for the gate spacer 200, refer to FIG. 11 and FIG. 21.

Step 5: Perform etching on the channel semiconductor layer between two gate spacers 200 to form a channel groove 300, and form a gate insulation layer 401 and a gate layer 402 that are successively disposed in the channel groove 300.

For example, for the channel groove 300, refer to FIG. 12 and FIG. 2, and for the gate insulation layer 401 and the gate layer 402 that are successively disposed, refer to FIG. 13 and FIG. 23.

The following specifically describes step 1, step 2, step 3, step 4, and step 5 in the foregoing front end of line by using specific embodiments.

### Embodiment 1

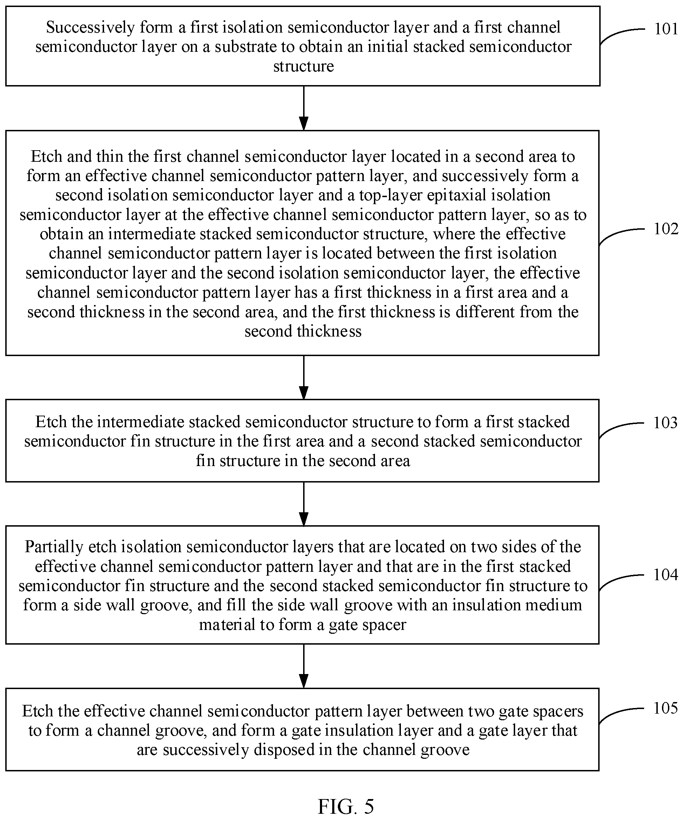

As shown in FIG. 5, this embodiment provides a front end of line for forming a plurality of vertical gate all around transistors in a semiconductor device, and the front end of line includes:
Step 101 (that is, step 1): As shown in FIG. 6, successively form a first isolation semiconductor layer A1 and a first channel semiconductor layer B1 on a substrate 01 to obtain an initial stacked semiconductor structure P1.

Schematically, referring to FIG. 6, in some possible implementations, the substrate 01 (also referred to as a substrate baseplate) may use a silicon (Si) substrate (also referred to as a silicon baseplate); and first form a SiGe layer (that is, the first isolation semiconductor layer A1) on the Si substrate (01), and then form a Si layer (that is, the first channel semiconductor layer B1) on the SiGe layer, so as to form the initial stacked semiconductor structure P1.

Certainly, referring to FIG. 6, in practice, before the initial stacked semiconductor structure P1 is formed, wells W that are independently disposed may be separately formed in an ion implantation manner at positions corresponding to a plurality of to-be-formed vertical gate all around transistors (10, 20) on the Si substrate.

It may be understood that, for different types of vertical gate all around transistors, different types of ions may be used for implantation to form corresponding types of wells. For example, at a position corresponding to a to-be-formed N-type vertical gate all around transistor, a P-type well is formed by using boron (B) ion implantation. At a position corresponding to a to-be-formed P-type vertical gate all around transistor, an N-type well is formed by using phosphorus or arsenic (P or As) ion implantation.

Step 102 (that is, step 2): As shown in FIG. 6, FIG. 7, and FIG. 8, perform etching and thinning on the first channel semiconductor layer B 1 located in a second area s2 to form an effective channel semiconductor pattern layer C, and successively form a second isolation semiconductor layer A2 and a top-layer epitaxial isolation semiconductor layer T on the effective channel semiconductor pattern layer C to obtain an intermediate stacked semiconductor structure P2 (refer to FIG. 8). The effective channel semiconductor pattern layer C is located between the first isolation semiconductor layer A1 and the second isolation semiconductor layer A2. The effective channel semiconductor pattern layer C has a first thickness in a first area s1, and a second thickness in the second area s2, and the first thickness is different from the second thickness.

Referring to FIG. 7, it may be understood that the effective channel semiconductor pattern layer C is obtained after the second area s2 of the first channel semiconductor layer B 1 is etched and thinned, that is, the first thickness of the effective channel semiconductor pattern layer C in the first area s 1 is greater than the second thickness of the effective channel semiconductor pattern layer C in the second area s2. Therefore, channel lengths of vertical gate all around transistors subsequently formed by the effective channel semiconductor pattern layer C in the first area s1 and the second area s2 are different (for details, refer to subsequent related descriptions).

Schematically, the foregoing process of performing etching and thinning on the first channel semiconductor layer B 1 located in the second area s2 to form the effective channel semiconductor pattern layer C may include: first coating an upper surface of the first channel semiconductor layer B 1 with a photoresist (photoresist, PR), and then completing a patterning process by successively using processes such as exposure, development, and etching, so as to thin the second area s2 of the first channel semiconductor layer B1 to form an effective channel semiconductor pattern layer C (refer to FIG. 7) having areas (s1, s2) with different thicknesses.

Certainly, FIG. 7 is merely an example in which the effective channel semiconductor pattern layer C has two areas with different thicknesses for description. In practice, the photoresist may be coated for a plurality of times, and processes such as exposure, development, and etching are successively performed to complete a patterning process, so as to form an effective channel semiconductor pattern layer C having three or more areas with different thicknesses. This application sets no specific limitation thereto. In practice, disposing may be selected based on a requirement. The following embodiments are described by using an example in which an effective channel semiconductor pattern layer C has two areas with different thicknesses.

In addition, to ensure planarity of an upper surface of the top-layer epitaxial isolation semiconductor layer T (that is, a surface on a side that faces away from the substrate 01), to facilitate manufacturing of another film layer at the top-layer epitaxial isolation semiconductor layer T subsequently, in some possible implementations, after the intermediate stacked semiconductor structure P2 is obtained, planarization processing may be performed on the upper surface of the top-layer epitaxial isolation semiconductor layer T. For example, polishing processing may be performed on the upper surface of the top-layer epitaxial isolation semiconductor layer T by using chemical mechanical polishing (chemical mechanical polishing, CMP), so as to ensure flatness of the upper surface of the top-layer epitaxial isolation semiconductor layer T.

Step 103 (that is, step 3): Referring to FIG. 8 and FIG. 9, perform etching on the intermediate stacked semiconductor structure P2 to form a first stacked semiconductor fin structure F1 in the first area s1, and a second stacked semiconductor fin structure F2 in the second area s2.

Schematically, performing etching on the intermediate stacked semiconductor structure P2 may include: first coating an upper surface of the intermediate stacked semiconductor structure P2 with a photoresist, and then completing a patterning process by successively using processes such as exposure, development, etching, and peeling to form a plurality of independently disposed stacked semiconductor fin structures (F1, F2).

It should be noted that, in the plurality of independently disposed stacked semiconductor fin structures (F1, F2) formed in step 103, a part located in the effective channel semiconductor pattern layer C is used as a channel part of a to-be-formed vertical gate all around transistor. In this case, it may be understood that different channel lengths cl of a plurality of to-be-formed vertical gate all around transistors are determined by thicknesses of different areas of the effective channel semiconductor pattern layer C (that is, control and adjustment are performed in step 102). For widths cw of channel parts of the plurality of to-be-formed vertical gate all around transistors, a mask pattern of a mask plate used in an exposure process may be disposed in a process of performing patterning on the intermediate stacked semiconductor structure P2, so as to separately control the width cw, a shape, and the like of the channel part of each vertical gate all around transistor (that is, control and adjustment are performed in step 103).

That is, based on the manufacturing method in this application, lengths cl and widths cw of the channel parts of the plurality of vertical gate all around transistors can be separately controlled and adjusted by using one process based on an actual requirement. In addition, shapes of the channel parts of the plurality of vertical gate all around transistors may also be disposed based on an actual requirement, for example, may be cylindrical shapes or cube shapes. Therefore, a channel design degree of freedom of the vertical gate all around transistor is increased.

Step 104 (that is, step 4): Referring to FIG. 9 and FIG. 10, in the first stacked semiconductor fin structure F1 and the second stacked semiconductor fin structure F2, perform partial etching on isolation semiconductor layers (A1, A2) located on two sides of the effective channel semiconductor pattern layer C to form a side wall groove 100, and fill the side wall groove 100 with an insulation medium material to form a gate spacer 200 (refer to FIG. 10 and FIG. 11).

Schematically, the insulation medium material used by the gate spacer 200 formed in the side wall groove 100 may be one or more of silicon nitride, silicon oxide, or silicon oxynitride.

It should be noted that, referring to FIG. 10 and FIG. 11, when the side wall groove 100 located between the effective channel semiconductor pattern layer C and the substrate 01 is filled with the insulation medium material, all areas on the substrate 01 except an area for disposing the stacked semiconductor fin structure (F1, F2) may be directly covered with the insulation medium material. Certainly, this is not limited thereto. Alternatively, only the side wall groove 100 may be filled with the insulation medium material, and in a subsequent manufacturing process, an insulation layer is separately manufactured as required in areas on the substrate 01 except the area for disposing the stacked semiconductor fin structure (F1, F2).

Step 105 (that is, step 5): Referring to FIG. 11 and FIG. 12, perform etching on the effective channel semiconductor pattern layer C located between two gate spacers 200 to form a channel groove 300, and form a gate insulation layer 401 and a gate layer 402 (refer to FIG. 12 and FIG. 13) that are successively disposed in the channel groove 300.

In some possible implementations, to improve performance of a prepared vertical gate all around transistor, reduce a gate leakage quantity, and reduce gate capacitance and a key size of the vertical gate all around transistor, in step 105, forming the gate insulation layer 401 and the gate layer 402 that are successively disposed in the channel groove 300 may include:
forming, by using an HKMG process (high-k metal gate, that is, a high-k insulation layer + a metal gate process), a high dielectric constant insulation layer (401) and a metal gate layer (402) that are successively disposed in the channel groove 300, so as to complete a front end of line of the plurality of vertical gate all around transistors.

It may be understood that, when the HKMG process is used to form the high dielectric constant insulation layer (401) and the metal gate layer (402) by using an etching process, an anisotropic etching process may be used, and etching is performed only in a longitudinal direction without lateral etching, so that manufacturing of the high dielectric constant insulation layer (401) and the metal gate layer (402) can be completed under protection of gate spacers 200 on both sides.

Certainly, after the front end of line of the plurality of vertical gate all around transistors is completed, a back end of line needs to be interconnected and wired. This application sets no limitation on a specific manufacturing procedure of the back end of line. In practice, a manufacturing flow of the back end of line may be selected as required.

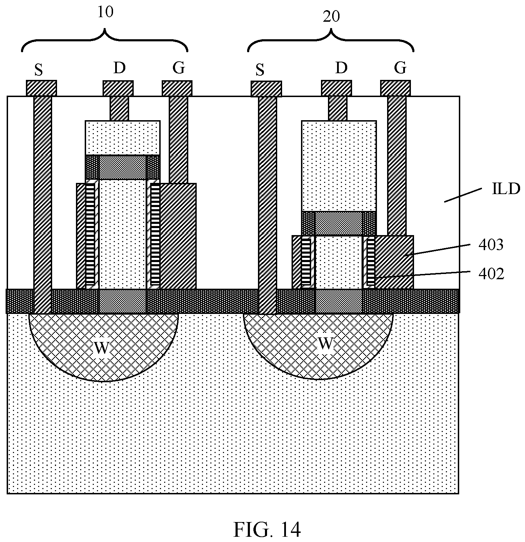

Schematically, referring to FIG. 13 and FIG. 14, in some possible implementations, a gate connection part 403 connected to the gate layer 402 may be first manufactured by using tungsten (W), then an inter layer dielectric (inter layer dielectric, ILD) is deposited, and through holes are formed and filled with metal (for example, tungsten) at positions, on the inter layer dielectric ILD by using an etching process, corresponding to a source S, a drain D, and a gate G of each vertical gate all around transistor, to complete manufacturing of the source S, the drain D, and the gate G.

### Embodiment 2

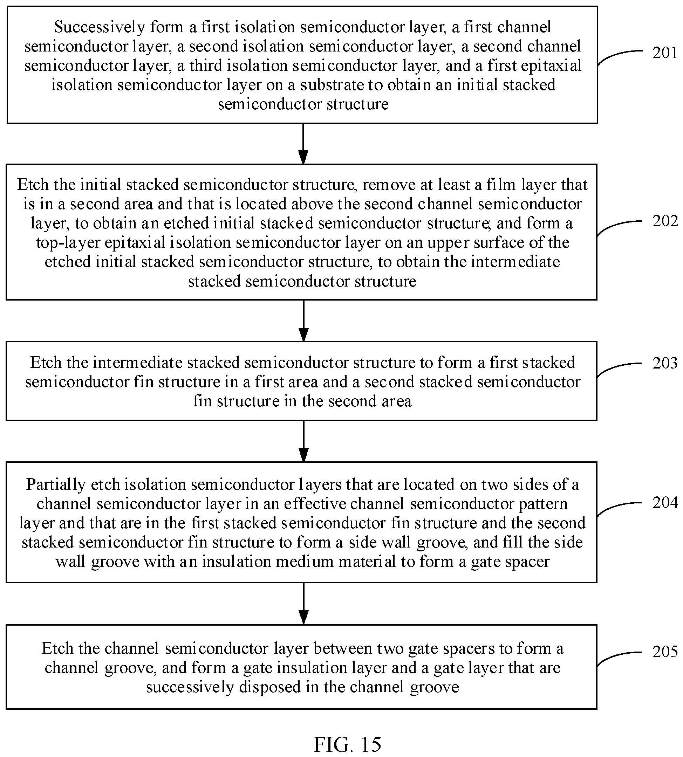

As shown in FIG. 15, this embodiment provides an FEOL for forming a plurality of vertical gate all around transistors in a semiconductor device, and the front end of line includes:
Step 201 (that is, step 1): As shown in FIG. 16, successively form a first isolation semiconductor layer A1, a first channel semiconductor layer B1, a second isolation semiconductor layer A2, a second channel semiconductor layer B2, a third isolation semiconductor layer A3, and a first epitaxial isolation semiconductor layer T' on a substrate 01, so as to obtain an initial stacked semiconductor structure P1.

Schematically, referring to FIG. 16, in some possible implementations, the substrate 01 (also referred to as a substrate baseplate) may use a silicon (Si) substrate. A SiGe layer (that is, A1), a Si layer (that is, B1), a SiGe layer (that is, A2), a Si layer (that is, B2), a SiGe layer (that is, A3), and a Si layer (that is, T') are successively formed on the Si substrate (01), so as to form the initial stacked semiconductor structure P1.

Certainly, referring to FIG. 16, in practice, before the initial stacked semiconductor structure P1 is formed, wells W that are independently disposed may be separately formed in an ion implantation manner at positions corresponding to a plurality of to-be-formed vertical gate all around transistors on the Si substrate.

Step 202 (that is, step 2): Referring to FIG. 16 and FIG. 17, perform etching on the initial stacked semiconductor structure P1, and remove at least a film layer that is in a second area s2 and that is located above the second channel semiconductor layer B2, to obtain an etched initial stacked semiconductor structure P1'; and form a top-layer epitaxial isolation semiconductor layer T on an upper surface of the etched initial stacked semiconductor structure P 1' to obtain an intermediate stacked semiconductor structure P2 (refer to FIG. 18).

Referring to FIG. 17, the etched initial stacked semiconductor structure P1' includes an effective channel semiconductor layer C, the effective channel semiconductor layer C includes, in the second area s2, one first channel semiconductor layer B1 sandwiched between the first isolation semiconductor layer A1 and the second isolation semiconductor layer A2, and the effective channel semiconductor layer C includes, in a first area s1, both the first channel semiconductor layer B1 sandwiched between the first isolation semiconductor layer A1 and the second isolation semiconductor layer A2, and the second channel semiconductor layer B2 sandwiched between the second isolation semiconductor layer A2 and the third isolation semiconductor layer A3. That is, a thickness of the effective channel semiconductor layer C in the first area s1 is a thickness sum of the first channel semiconductor layer B1 and the second channel semiconductor layer B2, and a thickness of the effective channel semiconductor layer C in the second area s2 is a thickness of the first channel semiconductor layer B1.

Schematically, performing etching on the initial stacked semiconductor structure P1 may include: first coating an upper surface of the first epitaxial isolation semiconductor layer T' with a photoresist (photoresist, PR), and then completing a patterning process of the initial stacked semiconductor structure P1 by successively using processes such as exposure, development, and etching, so as to form an effective channel semiconductor pattern layer C with different thicknesses in the first area s1 and the second area s2 (refer to FIG. 17).

It should be noted that, the foregoing "removing at least a film layer that is in a specified area and that is located above the second channel semiconductor layer B2" means that only the film layer that is in the second area s2 and that is located above the second channel semiconductor layer B2 may be removed, and the second channel semiconductor layer B2 is not etched; or a part of the second channel semiconductor layer B2 located in the second area s2 may be thinned while the film layer that is in the second area s2 and that is located above the second channel semiconductor layer B2 is removed.

It may be understood that, the manufacturing manner in which the part of the second channel semiconductor layer B2 located in the second area s2 is etched and thinned may be performed by using a manufacturing process with relatively low etching accuracy in a manufacturing procedure, thereby reducing a requirement on the manufacturing process.

In addition, to ensure planarity of an upper surface of the top-layer epitaxial isolation semiconductor layer T (that is, a surface on a side that faces away from the substrate 01), to facilitate manufacturing of another film layer at the top-layer epitaxial isolation semiconductor layer T subsequently, in some possible implementations, after the intermediate stacked semiconductor structure P2 is obtained, planarization processing may be performed on the upper surface of the top-layer epitaxial isolation semiconductor layer T. For example, polishing processing may be performed on the upper surface of the top-layer epitaxial isolation semiconductor layer T by using chemical mechanical polishing (chemical mechanical polishing, CMP) (refer to FIG. 18).

Step 203 (that is, step 3): Referring to FIG. 18 and FIG. 19, perform etching on the intermediate stacked semiconductor structure P2 to form a first stacked semiconductor fin structure F1 in the first area s1, and a second stacked semiconductor fin structure F2 in the second area s2.

Schematically, performing etching on the intermediate stacked semiconductor structure P2 may include: first coating an upper surface of the intermediate stacked semiconductor structure P2 with a photoresist, and then completing a patterning process by successively using processes such as exposure, development, etching, and peeling to form a plurality of independently disposed stacked semiconductor fin structures (F1, F2).

Based on the manufacturing method in this application, lengths and widths of channel parts of a plurality of vertical gate all around transistors can be separately controlled and adjusted by using one process based on an actual requirement. In addition, shapes of the channel parts of the plurality of vertical gate all around transistors may also be disposed based on an actual requirement, for example, may be cylindrical shapes or cube shapes.

Referring to FIG. 19, different channel lengths cl of a plurality of to-be-formed vertical gate all around transistors are determined by a thickness of the foregoing effective channel semiconductor pattern layer C (that is, control and adjustment are performed in step 201 with reference to step 202). Schematically, a length cl of a channel part of a vertical gate all around transistor formed by the stacked semiconductor fin structure F2 is a thickness of the first channel semiconductor layer B 1 formed in step 201, and a length cl of a channel part of a vertical gate all around transistor formed by the stacked semiconductor fin structure F1 is a total thickness of the first channel semiconductor layer B1 and the second channel semiconductor layer B2 that are formed in step 201.

For widths of channel parts of the plurality of to-be-formed vertical gate all around transistors, a mask pattern of a mask plate used in an exposure process may be disposed in a process of performing patterning on the intermediate stacked semiconductor structure P2, so as to separately control a width, a shape, and the like of the channel part of each vertical gate all around transistor. That is, a channel design degree of freedom of the vertical gate all around transistor is increased.

Step 204 (that is, step 4): Referring to FIG. 19 and FIG. 20, in the first stacked semiconductor fin structure F1 and the second stacked semiconductor fin structure F2, perform partial etching on isolation semiconductor layers on two sides of a channel semiconductor layer (B 1, B2) located in an effective channel semiconductor pattern layer to form a side wall groove 100, and fill the side wall groove 100 with an insulation medium material to form a gate spacer 200 (refer to FIG. 21).

Schematically, the insulation medium material used by the gate spacer 200 formed in the side wall groove 100 may be one or more of silicon nitride, silicon oxide, or silicon oxynitride.

It should be noted that when the side wall groove 100 is filled with the insulation medium material to form the gate spacer 200, areas on the substrate 0 1 except an area for disposing the stacked semiconductor fin structure (F1, F2) are covered with the insulation medium material. Certainly, this is not limited thereto. Alternatively, only an annular side wall groove 100 may be filled with the insulation medium material, and in a subsequent manufacturing process, an insulation layer is separately manufactured as required in areas on the substrate 01 except the area for disposing the stacked semiconductor fin structure (F1, F2).

Step 205 (that is, step 5): Referring to FIG. 21 and FIG. 22, perform etching on the channel semiconductor layer (B1, B2) located between two annular gate spacers 200 to form an annular channel groove 300, and form a gate insulation layer 401 and a gate layer 402 that are successively disposed in the annular channel groove 300 (refer to FIG. 22 and FIG. 23).

In some possible implementations, to improve performance of a prepared vertical gate all around transistor, reduce a gate leakage quantity, and reduce gate capacitance and a key size of the vertical gate all around transistor, in step 205, forming the gate insulation layer 401 and the gate layer 402 that are successively disposed in the annular channel groove 300 may include:
forming, by using an HKMG process (high-k metal gate, that is, a high-k insulation layer + a metal gate process), the high dielectric constant insulation layer (401) and the metal gate layer (402) that are successively disposed in the annular channel groove 300, so as to complete manufacturing of the front end of line of the plurality of vertical gate all around transistors.

Certainly, after the FEOL of the plurality of vertical gate all around transistors is completed, a BEOL is required for interconnection and wiring process. This application sets no limitation on a specific manufacturing procedure of the back end of line. In practice, a manufacturing flow of the BEOL may be set as required.

Schematically, referring to FIG. 23 and FIG. 24, in some possible implementations, a gate connection part 403 connected to the gate layer 402 may be first manufactured by using tungsten (W), then an inter layer dielectric ILD is deposited, and through holes are formed and filled with metal (for example, tungsten) at positions, on the inter layer dielectric ILD by using an etching process, corresponding to a source S, a drain D, and a gate G of each vertical gate all around transistor, to complete manufacturing of the source S, the drain D, and the gate G.

It should be noted that the foregoing Embodiment 1 and Embodiment 2 are merely two types of FEOLs for forming a plurality of vertical gate all around transistors schematically given in this application. However, this application is not limited thereto, and any adjustment or change based on Embodiment 1 and Embodiment 2 shall fall within the protection scope of this application.

For example, compared with Embodiment 2 where two channel semiconductor layers (B1, B2) are manufactured in step 201, and a vertical gate all around transistor with two channel lengths (one is a thickness of the first channel semiconductor layer, and the other is a thickness sum of the first channel semiconductor layer and the second channel semiconductor layer) can be finally obtained, in some other possible implementations, three channel semiconductor layers (upper, middle, and lower) may be manufactured, and then a vertical gate all around transistor with three channel lengths may be obtained, that is, a channel length of the vertical gate all around transistor is a thickness of a lower-layer channel semiconductor layer, a channel length of the vertical gate all around transistor is a thickness sum of the lower-layer channel semiconductor layer and a middle-layer channel semiconductor layer, and another channel length of the vertical gate all around transistor is a thickness sum of the three channel semiconductor layers. For a related manufacturing procedure, refer to related descriptions in Embodiment 2. Details are not described herein again.

For another example, in some possible implementations, two channel semiconductor layers may be manufactured, and only an upper-layer channel semiconductor layer is etched in the manner in step 102 in Embodiment 1, that is, the upper-layer channel semiconductor layer is etched into an area with different thicknesses. In this case, thickness sums of an upper-layer channel semiconductor layer after patterned in areas with different thicknesses and a lower-layer channel semiconductor layer are respectively used as a channel length of each vertical gate all around transistor. For a related manufacturing procedure, refer to related descriptions in Embodiment 1 and Embodiment 2. Details are not described herein again.

In conclusion, by using the manufacturing method provided in this embodiment of this application, an effective channel semiconductor pattern layer having areas with different thicknesses can be manufactured through etching, and areas with different thicknesses of the effective channel semiconductor pattern layer are used as channel length areas of a vertical gate all around transistor subsequently. In addition, in a manufacturing procedure, a channel shape (for example, a cylindrical shape or a cube shape) of a vertical gate all around transistor can be further controlled based on an actual requirement through etching. That is, by using the manufacturing method in this application, at least two vertical gate all around transistors with different channel lengths (gate lengths) can be simultaneously manufactured by using one process, that is, a channel design degree of freedom of the vertical gate all around transistor is increased, and a long channel gate all around transistor and a short channel gate all around transistor can be simultaneously formed, thereby increasing an application range of the semiconductor device.

In addition, it should be noted that all the foregoing embodiments are described by using an example in which an isolation semiconductor layer (for example, A1, A2, and A3) uses SiGe, and a channel semiconductor layer (for example, B1 and B2) and an epitaxial semiconductor layer (for example, T' and T) use Si. However, this application is not limited thereto, and a semiconductor material used by each semiconductor layer may be adjusted based on an actual requirement. It is only necessary to ensure that semiconductor materials used by adjacent semiconductor layers are different. For example, in some possible implementations, all isolation semiconductor layers (for example, A1, A2, and A3) may use Si, and all channel semiconductor layers (for example, B1 and B2) and epitaxial semiconductor layers (for example, T' and T) may use SiGe (components of Si and Ge may be adjusted based on a requirement). Certainly, epitaxial semiconductor layers (such as T' and T) disposed adjacent to each other may use a same semiconductor material.

In addition, for a related disposing structure in the foregoing semiconductor device embodiment, refer to the foregoing semiconductor device manufacturing method. For other related content in the foregoing semiconductor device manufacturing method, refer to a corresponding part in the foregoing semiconductor device embodiment. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor device, comprising: a substrate and a first semiconductor fin and a second semiconductor fin that are located on the substrate, wherein
the first semiconductor fin comprises a plurality of stacked isolation semiconductor pattern layers and at least one channel semiconductor pattern layer, and each channel semiconductor pattern layer is sandwiched between two isolation semiconductor pattern layers;
the second semiconductor fin comprises a first isolation semiconductor pattern layer, a first channel semiconductor layer, and a second isolation semiconductor pattern layer that are successively stacked; and
a total thickness of all channel semiconductor pattern layers in the first semiconductor fin is different from a thickness of the first channel semiconductor pattern layer.

2. The semiconductor device according to claim 1, wherein
semiconductor materials in a channel semiconductor pattern layer closest to the substrate in the first semiconductor fin and the first channel semiconductor pattern layer are the same.

3. The semiconductor device according to claim 1 or 2, wherein
the first semiconductor fin comprises a third isolation semiconductor pattern layer, a second channel semiconductor pattern layer, and a fourth isolation semiconductor pattern layer that are successively disposed on the substrate; and
a thickness of the second channel semiconductor pattern layer is different from the thickness of the first channel semiconductor pattern layer.

4. The semiconductor device according to claim 3, wherein
the third isolation semiconductor pattern layer is closer to the substrate relative to the fourth isolation semiconductor pattern layer;
the first isolation semiconductor pattern layer is closer to the substrate relative to the second isolation semiconductor pattern layer;
thicknesses of the third isolation semiconductor pattern layer and the first isolation semiconductor pattern layer are the same, and semiconductor materials in the third isolation semiconductor pattern layer and the first isolation semiconductor pattern layer are the same; and
thicknesses of the fourth isolation semiconductor pattern layer and the second isolation semiconductor pattern layer are the same, and semiconductor materials in the fourth isolation semiconductor pattern layer and the second isolation semiconductor pattern layer are the same.

5. The semiconductor device according to claim 1 or 2, wherein
the first semiconductor fin comprises a fifth isolation semiconductor pattern layer, a third channel semiconductor pattern layer, a sixth isolation semiconductor pattern layer, a fourth channel semiconductor pattern layer, and a seventh isolation semiconductor pattern layer that are successively disposed on the substrate; and
a thickness of the third channel semiconductor pattern layer is the same as the thickness of the first channel semiconductor pattern layer.

6. The semiconductor device according to claim 5, wherein
the fifth isolation semiconductor pattern layer is closer to the substrate relative to the sixth isolation semiconductor pattern layer;
the first isolation semiconductor pattern layer is closer to the substrate relative to the second isolation semiconductor pattern layer;
thicknesses of the fifth isolation semiconductor pattern layer and the first isolation semiconductor pattern layer are the same, and semiconductor materials in the fifth isolation semiconductor pattern layer and the first isolation semiconductor pattern layer are the same; and
thicknesses of the sixth isolation semiconductor pattern layer and the second isolation semiconductor pattern layer are the same, and semiconductor materials in the sixth isolation semiconductor pattern layer and the second isolation semiconductor pattern layer are the same.

7. The semiconductor device according to any one of claims 1 to 6, wherein
in the first semiconductor fin, gate spacers are disposed on sides around isolation semiconductor pattern layers on both sides of each channel semiconductor pattern layer, and a gate insulation layer and a gate layer are successively disposed on sides around the channel semiconductor pattern layer and between two gate spacers; and
in the second semiconductor fin, gate spacers are disposed on sides around the first isolation semiconductor pattern layer and the second isolation semiconductor pattern layer, and a gate insulation layer and a gate layer are successively disposed on sides around the first channel semiconductor layer and between two gate spacers.

8. A manufacturing method for a semiconductor device, comprising:
forming an initial stacked semiconductor structure on a substrate, wherein the initial stacked semiconductor structure comprises at least one isolation semiconductor layer and at least one channel semiconductor layer that are formed alternately on the substrate;
etching the initial stacked semiconductor structure to form an intermediate stacked semiconductor structure, wherein the intermediate stacked semiconductor structure comprises an effective channel semiconductor layer, the effective channel semiconductor layer is located between two isolation semiconductor layers, the effective channel semiconductor layer has a first thickness in a first area and a second thickness in a second area, the first thickness is different from the second thickness, and the first area and the second area are different areas; and
etching the intermediate stacked semiconductor structure to form a first semiconductor fin structure in the first area and a second semiconductor fin structure in the second area.

9. The manufacturing method for a semiconductor device according to claim 7, wherein
a top-layer epitaxial isolation semiconductor layer is disposed at an uppermost layer of the intermediate stacked semiconductor structure; and
before the etching the intermediate stacked semiconductor structure, the manufacturing method for a semiconductor device further comprises:
performing planarization processing on an upper surface of the top-layer epitaxial isolation semiconductor layer.

10. The manufacturing method for a semiconductor device according to claim 8 or 9, wherein
the forming an initial stacked semiconductor structure on a substrate comprises:
successively forming a first isolation semiconductor layer and a first channel semiconductor layer on the substrate to obtain the initial stacked semiconductor structure; and
the etching the initial stacked semiconductor structure to form an intermediate stacked semiconductor structure comprises:
etching and thinning the first channel semiconductor layer located in the second area to form the effective channel semiconductor layer; and
successively forming a second isolation semiconductor layer and a top-layer epitaxial isolation semiconductor layer at the effective channel semiconductor layer, so as to obtain the intermediate stacked semiconductor structure.

11. The manufacturing method for a semiconductor device according to claim 8 or 9, wherein
the forming an initial stacked semiconductor structure on a substrate comprises:
successively forming a first isolation semiconductor layer, a first channel semiconductor layer, a second isolation semiconductor layer, a second channel semiconductor layer, a third isolation semiconductor layer, and a first epitaxial isolation semiconductor layer on the substrate to obtain the initial stacked semiconductor structure; and
the etching the initial stacked semiconductor structure to form an intermediate stacked semiconductor structure comprises:
etching the initial stacked semiconductor structure, and removing at least a film layer that is in the second area and that is located above the second channel semiconductor layer, to obtain an etched initial stacked semiconductor structure, wherein the etched initial stacked semiconductor structure comprises the effective channel semiconductor layer, and the effective channel semiconductor layer comprises one channel semiconductor layer in the second area, and comprises two channel semiconductor layers in the first area; and
forming a top-layer epitaxial isolation semiconductor layer on an upper surface of the etched initial stacked semiconductor structure, to obtain the intermediate stacked semiconductor structure.

12. The manufacturing method for a semiconductor device according to claim 11, wherein
the removing at least a film layer that is in the second area and that is located above the second channel semiconductor layer comprises:
removing the film layer that is in the second area and that is located above the second channel semiconductor layer, and reducing a thickness of the second channel semiconductor layer in the second area.

13. The manufacturing method for a semiconductor device according to any one of claims 8 to 12, wherein after the etching the intermediate stacked semiconductor structure to form a first semiconductor fin structure in the first area and a second semiconductor fin structure in the second area, the method further comprises:
partially etching an isolation semiconductor layer in each of the first semiconductor fin structure and the second semiconductor fin structure to form a side wall groove, and filling the side wall groove with an insulation medium material to form a gate spacer; and
etching a channel semiconductor layer between two gate spacers to form a channel groove, and forming a gate insulation layer and a gate layer that are successively disposed in the channel groove.

14. The manufacturing method for a semiconductor device according to claim 13, wherein
the forming a gate insulation layer and a gate layer that are successively disposed in the channel groove comprises:
forming, by using an HKMG process, a high dielectric constant insulation layer and a metal gate layer that are successively disposed in the channel groove.

15. An electronic device, comprising the semiconductor device according to any one of claims 1 to 7.
